# EUROPEAN PATENT APPLICATION

(11) **EP 2 887 077 A1**
(43) Date of publication of application: **24.06.2015**
(21) Application number: 14198516.8
(22) Date of filing: 17.12.2014
(51) Int. Cl.: G01R 19/165, G01R 31/01, H02H 7/16

(54) **Capacitor failure indication circuit**

(30) Priority: 19.12.2013 IN MU39742013
(71) Applicant: Control Techniques Ltd, Newtown, Powys SY16 3BE (GB)
(72) Inventor: Baburaj, Rajkumar, 412101 Pune (IN)
(74) Representative: Noble, Nicholas

(57) **Abstract**

A circuit (110) is arranged to detect a voltage imbalance between two nodes (136,138) indicative of component (114,116) failure and, upon such detection, convey an optical signal (124,130) to indicate that a component appears to have failed.

## Description

This disclosure relates to the failure of capacitors. In particular, but without limitation, this disclosure relates to the identification of a capacitor that has failed.

Electrical power can be provided for use in the form of a Direct Current (DC) voltage and also in the form of an Alternating Current (AC) voltage that has been rectified by applying an AC voltage waveform to a half- or full-wave rectifier so as to produce a rectified voltage. Rectified voltages typically exhibit voltage ripple and may be smoothed by a capacitor in order to reduce the ripple.

Aspects and features of the present disclosure are set out in the appended claims.

There is described herein a capacitor failure indication circuit, the capacitor failure indication circuit being arranged for connection between a first circuit node and a second circuit node, wherein: the first circuit node is the common connection point of a first capacitor and a second capacitor that are connected in series; the second circuit node is the common connection point of a first resistor and a second resistor that are connected in series; the series connected first and second capacitors are connected in parallel to the series connected first and second resistors; the ratio of the impedance of the second capacitor to the sum of the impedances of the first and second capacitors is the same as the ratio of the impedance of the second resistor to the sum of the impedances of the first and second resistors, the capacitor failure indication circuit comprising: a first Zener diode having its anode arranged for connection to the first circuit node; a second Zener diode having its anode arranged for connection to the second circuit node; a first Light Emitting Diode, LED, having its anode connected to the cathode of the first Zener diode and its cathode connected to the cathode of the second Zener diode; and a second LED having its anode connected to the cathode of the second Zener diode and its cathode connected to the cathode of the first Zener diode.

There is also described herein a capacitor failure indication circuit comprising: a first Zener diode; a second Zener diode; a first Light Emitting Diode, LED, having its anode connected to the cathode of the first Zener diode and its cathode connected to the cathode of the second Zener diode; and a second LED having its anode connected to the cathode of the second Zener diode and its cathode connected to the cathode of the first Zener diode.

These circuits use only a few components in order to indicate component failure when a voltage difference between two potential dividers occurs. By making optical triggering or indications, the capacitor failure indication circuits are able to electrically isolate the supply voltage (which may be at a high voltage) from any control circuitry arranged to process the indication (which may be at a low voltage). Furthermore, by using multiple LEDs, the capacitor failure indication circuits are able to convey information with regard to which of the capacitors is faulty - thereby reducing fault diagnosis times and facilitating repair.

Also, by using a pair of parallel connected potential dividers (respectively formed by the first and second capacitors and the first and second resistors) and detecting a voltage difference between nodes of those potential dividers, fluctuations in the voltage supplied across the potential dividers, or creepage of that voltage, do not cause false indications. As system size is a concern when a low voltage circuit is implemented along with the DC link area of a power system, the use of optocouplers advantageously enables a PCB design that reduces the spacing required for isolation between high voltages and low voltages.

As the capacitor failure indication circuits are connected between nodes of the potential dividers, they are not exposed to the full DC voltage with respect to either ground or the negative power rail that is developed at the nodes and so can be used for nodes that are designed to operate at voltages that are in excess of the voltages that the components of the capacitor failure indication circuits - for example as may occur in multi-level voltage converters. Put another way, the voltage ratings of individual capacitor failure indication circuit components are not dependent on the DC voltage with respect to ground and the current rating of the components of the indication circuit depends only on the resistors used in the potential dividers. However, those resistors do limit the flow of high current during differential nodes at the time of capacitor failure.

By providing an indication of capacitor failure before the whole circuit fails, the voltage supply to the circuit may be disrupted, for example by disconnecting the power supply or removing a thyristor gate signal and/or by connecting a inrush resistor to the DC rail and so further component damage or indeed catastrophic failure may be avoided.

When the capacitor failure indication circuit further comprises the first and second resistors, the first and second resistors beneficially have dual functionality as they not only enable the capacitor failure indication circuit to determine voltage imbalances as would be caused by capacitor failure, but also function as bleed resistors by which charge stored in the capacitors can be discharged following turn off.

Examples of the present disclosure will now be explained with reference to the accompanying drawings in which:
Figure 1 shows a circuit diagram having a pair of interlink capacitors and an indication circuit for indicating failure of one of the capacitors;
Figure 2 shows a circuit diagram having a pair of interlink capacitors and an indication circuit for indicating failure of one of the capacitors;
Figure 3 shows a circuit diagram in which an indication circuit as described herein may be employed;
Figure 4 shows a circuit diagram in which an indication circuit as described herein may be employed;
Figure 5 shows a circuit diagram having three interlink capacitors and an indication circuit for indicating failure of one of the capacitors;
Figure 6 shows a circuit diagram having three interlink capacitors and an indication circuit for indicating failure of one of the capacitors;
Figure 7 shows a circuit diagram having three interlink capacitors and an indication circuit for indicating failure of one of the capacitors;
Figure 8 shows a circuit diagram having a series of n interlink capacitors and an indication circuit for indicating failure of one of the capacitors;
Figure 9 shows a circuit diagram employing two of the indication circuits described herein;
Figure 10 shows a circuit diagram in which an indication circuit is employed;
Figure 11 shows an alternative configuration of the circuit of Figure 1; and
Figure 12 shows an alternative configuration of the circuit of Figure 2.

In industrial applications, voltage converters can be provided with three phase AC voltages of 400V that, when rectified produce nominal DC voltages of 500V or above. Capacitors rated at 400V or 450V cannot be safely connected across such a nominal voltage and so, in order to allow safe operation and prolong component lifetime, a plurality of capacitors (called bulk capacitors) are connected in series to the rectifier output. Even though the bulk capacitors are connected in series, power loss and variations in operating temperatures will affect the lifetime of the bulk capacitors and eventually one of the bulk capacitors will fail. However, unless such a failure is quickly identified, it will likely result in the remaining bulk capacitor(s) being exposed to an elevated voltage which can then cause the remaining bulk capacitor(s) to fail.

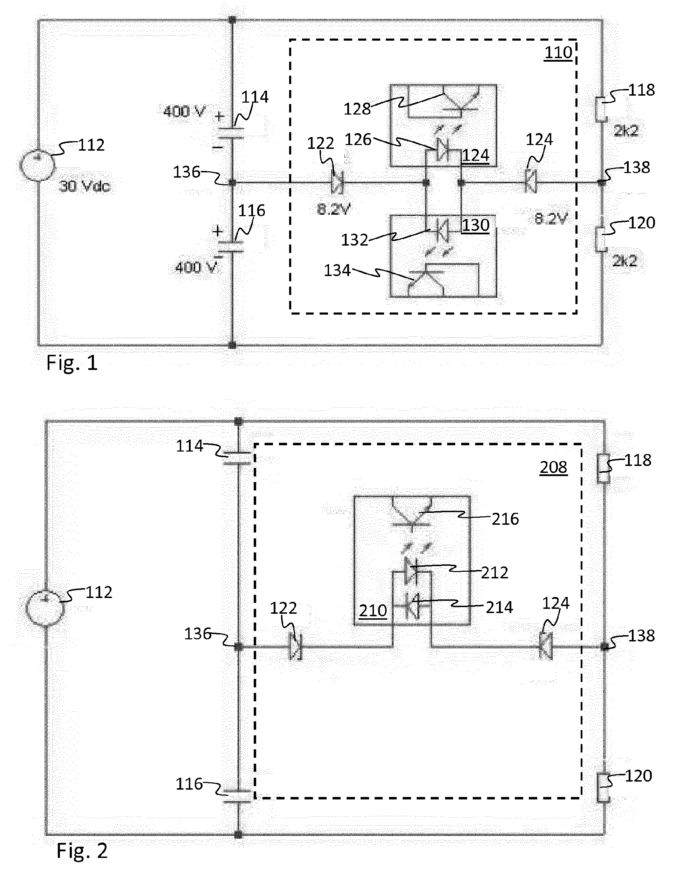

Figure 1 shows a circuit having a pair of interlink capacitors and an indication circuit 110 for indicating failure of one of the capacitors. In the circuit of Figure 1, a 30V DC voltage supply 112, for example as may be produced by a bridge rectifier (not shown), develops a voltage across a first capacitor 114 and a second capacitor 116 that are in series. The voltage supply 112 also develops that same voltage across a first resistor 118 and a second resistor 120 that are in series and the series connected first and second capacitors 114 and 116 and are in parallel with the series connected first and second resistors 118 and 120. The anode of a first Zener diode 122 is connected to a first circuit node 136 which is at the common connection point of the series connected capacitors 114 and 116. A second Zener diode 124 has its anode connected to a second circuit node 138 which is at the common connection point of the series connected resistors 118 and 120. A first optocoupler 124 comprising a first Light Emitting Diode (LED) 126 and a first phototransistor 128 is connected between the cathodes of the first and second Zener diodes 122 and 124 so that the anode of the first LED 126 is connected to the cathodes of the first Zener diode 122 and the cathode of the first LED 126 is connected to the cathode of the second Zener diode 124. A second optocoupler 130 is coupled between the cathode of the first and second Zener diodes 122 and 124 and comprises a second LED 132 and a second phototransistor 134. The anode of the second LED 132 is connected to the cathode of the second Zener diode 124 and the cathode of the second LED 132 is connected to the cathode of the first Zener diode 122. The ratio of the impedance of the second capacitor 116 to the sum of the impedances of the first and second capacitors 114, 116 is the same as the ratio of the impedance of the second resistor 120 to the sum of the impedances of the first and second resistors 118, 120. In the circuit of Figure 1, the first and second resistors 118 and 120 have resistances of 2.2 KΩ, the first and second capacitors 114 and 116 have voltage ratings of 400 volts and are electrolytic capacitors and the first and second Zener diodes 122 and 124 have Zener breakdown voltages of 8.2 Volts. The 30 volt DC supply of voltage source 112 is set to that voltage for testing purposes. In normal operation the voltage supplied by the voltage supply 112 would typically be in excess of the maximum operating voltages of the first and second capacitors 114 and 116.

The first and second capacitors 114 and 116 and the first and second resistors 118 and 120 respectively act as voltage dividers. Accordingly, the voltage at circuit node 136 is dependent on the ratio of the impedance of the second capacitor 116 to the sum of the impedances of the first and second capacitors 114, 116 and the voltage at circuit node 138 is dependent on the ratio of the impedance of the second resistor 120 to the sum of the impedances of the first and second resistors 118, 120. In this instance, the first and second capacitors 114 and 116 have the same capacitances and the first and second resistors 118 and 120 have the same resistances and so, in normal operation, the voltage at circuit node 136 will be approximately half of the voltage that is supplied by the voltage source 112 (approximately 15 volts) and the voltage at circuit node 138 will also be approximately half of the voltage that is supplied by the voltage source 112. Accordingly, in normal operation there is little or no potential difference between the first and second circuit nodes 136 and 138 and so neither of the first or second Zener diodes 122 and 124 is reversed biased by a voltage that is greater than their Zener breakdown voltage and so no current flows between the circuit nodes 136 and 138. In order to avoid false triggering of the circuit of Figure 1, the ratio of the impedance of the second capacitor to the sum of the impedances of the first and second capacitors should be the same as the ratio of the impedance of the second resistor to the sum of the impedances of the first and second resistors. In particular, for a given supply voltage V, the modulus of the difference between the ratio of the impedance of the second capacitor to the sum of the impedances of the first and second capacitors and the ratio of the impedance of the second resistor to the sum of the impedances of the first and second resistors should be less than the sum of the Zener breakdown voltage plus the Zener diode forward voltage plus the LED forward voltage all divided by the supply voltage.

In the event that the first capacitor 114 fails so as to short out its connections, then the voltage supplied by the voltage source 112 will be developed entirely across the second capacitor 116 and so the voltage at the first circuit node 136 will be significantly in excess of the voltage at the second circuit node 138. When the voltage at the first circuit node 136 is in excess of the voltage at the second circuit node 138 by a voltage that is equal to or greater than the sum of the forward voltage of the first Zener diode 122 plus the forward voltage of the first LED 126 plus the Zener breakdown voltage of the second Zener diode 124, current (which will be limited by the second resistor 120) will flow from the first circuit node 136 to the second circuit node 138 via the first LED 126 which will accordingly illuminate and consequently turn on the base of the first phototransistor 128.

In the event that the first capacitor 114 fails by open circuiting its connections then the voltage at the first circuit node 136 will fall below the voltage at the second circuit node 138. When the voltage at the second circuit node 138 is more than that at the first circuit node 136 by an amount that is greater than or equal to the sum of the forward voltage of the second Zener diode 124 plus the forward voltage of the second LED 132 plus the Zener breakdown voltage of the first Zener diode 122, then current will flow from the first circuit node 138 to the second circuit node 136 and the second LED 132 will illuminate and consequently turn on the base of the second phototransistor 134.

In the event that the second capacitor 116 fails and short circuits its terminals, then the voltage at the first circuit node 136 will drop below the voltage at the second circuit node 138 and the second LED 132 will illuminate thereby triggering the base of the second phototransistor 134.

In the event that the second capacitor 116 fails and open circuits its terminals, then the voltage at the first circuit node 136 will rise and the first LED 126 will illuminate and trigger the base of the first phototransistor 128.

Accordingly, the capacitor failure indication circuit is capable not only of detecting capacitor failure by way of open circuiting, but also by way of closed circuiting. Short circuit failures are generally more significant (and frequent) than open circuit capacitor failures because, if a capacitor open circuits, then the condition of the system will not further deteriorate and the only end result will be that a supplied rectified DC voltage will not be filtered. In contrast, if one of the capacitors short circuits, then it will cause an over voltage or elevated voltage to be developed across one or more adjoining series capacitors which ultimately will cause further, and potentially catastrophic, failure. The capacitor failure indication circuit can differentiate between an open circuit capacitor failure and a closed circuit capacitor failure by comparison of the charge time constant expected if the capacitor was functioning normally. In particular, once a normally functioning capacitor is charged to a voltage equivalent to the nodal voltage 138, current will reduce and the optocoupler will be turned off.

The triggering of the phototransistors of either of the first and second optocouplers 124 or 130 causes the generation of signals that can be used to disconnect the voltage supply 112 (means for doing so not shown). By disconnecting the voltage supply 112 once it has been determined that one of the capacitors has failed, subsequent damage to other capacitors and/or circuit components may be avoided. Furthermore, knowledge of the circumstances that would cause the first or second LED 126, 132 to illuminate can also be used to identify which capacitor has failed. For example, in circumstances where it is expected that a capacitor would only fail by short circuiting, then illumination of the first LED 126 would indicate that the first capacitor 114 had failed and illumination of the second LED 132 would indicate that the second capacitor 116 had failed. Accordingly, signals produced by the first and second phototransistors 128, 134 may be recorded so that, when it is time to repair or maintain the system, a person charged with performing the repair or maintenance operation can determine which capacitor needs to be replaced. As one possibility, a record is made of not only which optocouplers illuminate, but also of how long they illuminate for. That information can subsequently be used to determine whether open or closed circuit capacitor faults occurred and may also be used to identify which capacitor has failed.

Figure 2 shows an indication circuit 208 that, instead of having first and second optocouplers, has a bidirectional optocoupler 210 comprising the first and second LEDs 212, 214 and a single phototransistor 216. The bidirectional optocoupler 210 is connected between the cathodes of the first and second Zener diodes 122 and 124. Operation of the circuit of Figure 2 is the same as that of Figure 1 except that, as the optocoupler 210 has only a single phototransistor 216, and as the phototransistor 216 may be triggered by illumination of either of the first and second LEDs 212, 214, only a single signal in produced when one or other of the first and second LEDs 212, 214 illuminates. Accordingly, it is not possible to determine from that signal which of the first and second capacitors 114 and 116 has failed.

By using light to indicate that a capacitor has failed, electrical isolation is provided between the voltage supply and any circuitry used to process signals generated by the phototransistor(s).

As one possibility, instead of using LEDs that are part of an optocoupler, one or more standalone LEDs may be used to provide visual warnings that one of the capacitors has failed.

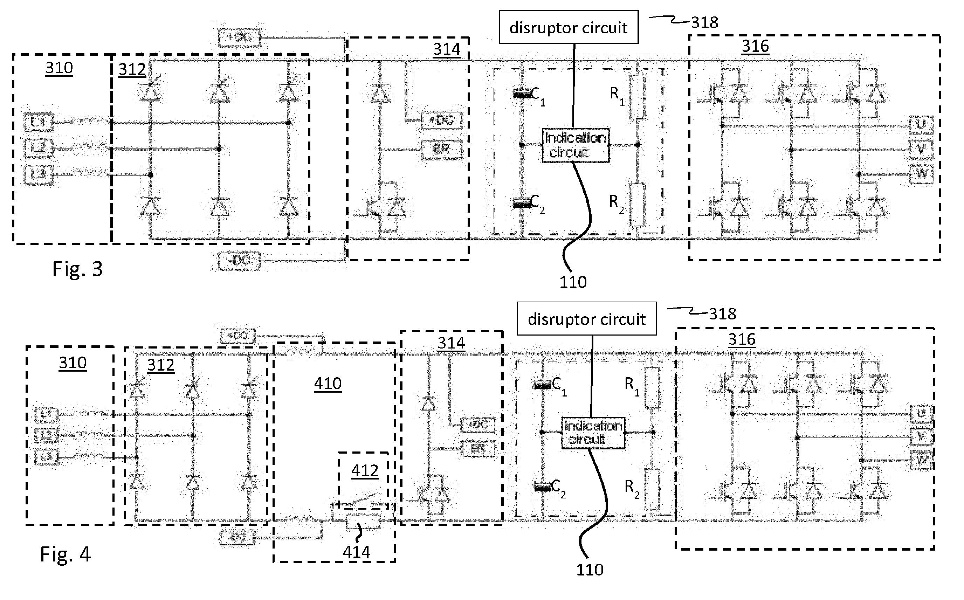

Figure 3 shows the capacitor failure indication circuit 110 in a variable frequency drive (VFD) or phase converter application. Circuit element 310 has connections L1, L2, L3 and can be considered as acting as a generator output or a utility 400V AC supply which is rectified by a three phase thyristor controlled rectifier 312. A circuit element 314 employs a braking transistor and resistor and the circuit further has a VFD output section 316 having connection elements U, V, W. In operation, if a load motor is connected across connection elements UVW, kickback energy produced during motor deceleration is dissipated via circuit element 314.

In the circuit of Figure 3, once one of the LEDs has been illuminated, a disruptor circuit 318 control the thyristors of the controlled rectifier 312 (for example by removing signals supplied to their gates) so as to disconnect circuit element 310 thereby preventing further damage occurring.

Figure 4 shows a circuit similar to that of Figure 3 but this time having an inrush circuit 410 with a relay 412 that is operable to a bypass an inrush resistor 414 once a circuit has reached a steady state after turn on. In the circuit of Figure 4, when the indication circuit 110 determines that one of the capacitors has failed, the disruptor circuit 318 opens the relay 412 of the inrush circuit 410 so as to reduce the load on the drive by making the supply current pass through the inrush resistor 414. In addition, for the circuit of Figure 4, once one of the LEDs has been illuminated, control circuitry (not shown) may be used to control the thyristors of the controlled rectifier 312 so as to disconnect the circuit element 310 thereby preventing any further damage occurring.

As one possibility, a 3 phase contactor may be connected to a three-phase input voltage that is subsequently rectified before supplying the series connected capacitors. Upon determination that one of the LEDs has illuminated, the disruptor circuit 318 sends a signal to the contactor to cut off the supply to the rectifier.

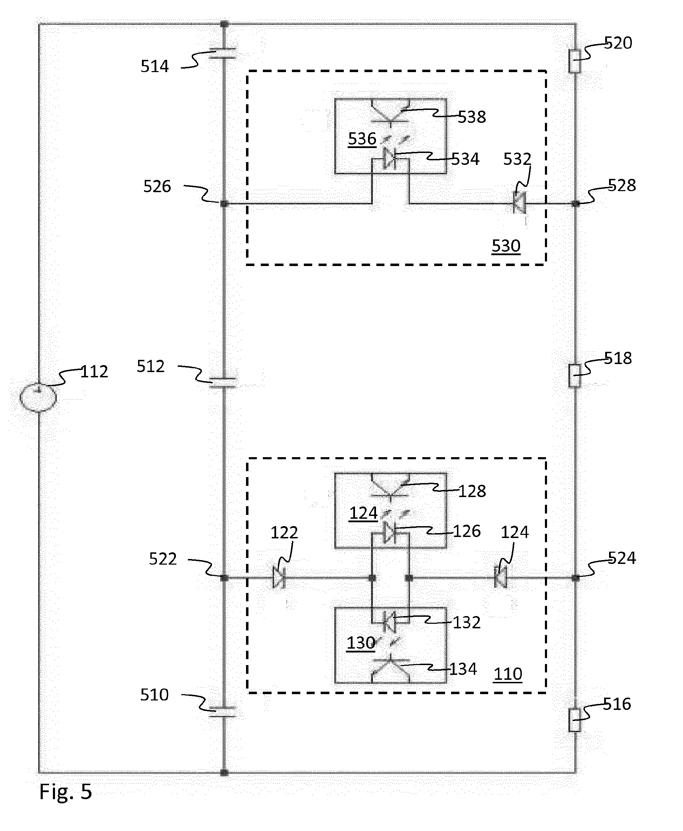

In the circuit of Figure 5, first, second, and third capacitances 510, 512, and 514 are arranged in series with each other and together are in parallel with series connected first, second, and third resistances 516, 518, and 520. A capacitor failure indication circuit 110 is connected between first and second circuit nodes 522, 524 which are respectively the common connection points of the first and second capacitors 510, 512 and the common connection points of the first and second resistors 516, 518. Furthermore, the circuit of Figure 5 has a further indication circuit 530 which has a third Zener diode 532, the anode of which is connected to a third circuit node 528 which lies at the common connection point of the second and third resistors 518, 520. A third LED 534 which forms part of a third optocoupler 536 has its cathode connected to the cathode of the third Zener diode 532 and its anode connected to a fourth circuit node 526 which is the common connection point of the second and third capacitors 512, 514.

When the circuit of Figure 5 is in operation, in the event that the voltage at the first circuit node 522 is significantly lower than that at the second circuit node 524, then the second LED 132 illuminates. In the event that the voltage at the first circuit node 522 is significantly greater than the voltage at the second node 524, then the first LED 126 illuminates. Also, if the voltage at the third circuit node 526 is significantly higher than the voltage at the fourth circuit node 528, then the third LED 534 illuminates.

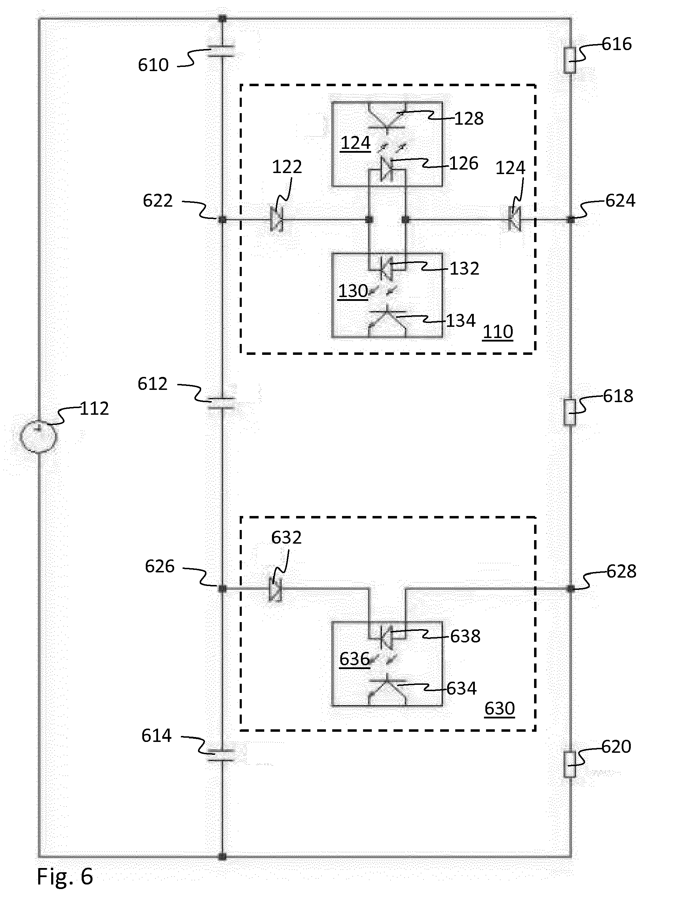

In the circuit of Figure 6, first, second, and third capacitances 610, 612, and 614 are arranged in series with each other and together are in parallel with series connected first, second, and third resistances 616, 618, and 620. A capacitor failure indication circuit 110 is connected between first and second circuit nodes 622, 624 which are respectively the common connection points of the first and second capacitors 610, 612 and the common connection points of the first and second resistors 616, 618. Furthermore, the circuit of Figure has a further indication circuit 630 which has a third Zener diode 632, the anode of which is connected to a third circuit node 626 which lies at the common connection point of the second and third capacitors 612, 614. A third LED 634 which forms part of a third optocoupler 636 has its cathode connected to the cathode of the third Zener diode 632 and its anode connected to a fourth circuit node 628 which is the common connection point of the second and third resistors 618, 620.

When the circuit of Figure 6 is in operation, in the event that the voltage at the first circuit node 622 is significantly lower than that at the second circuit node 624, then the second LED 132 illuminates. In the event that the voltage at the first circuit node 622 is significantly greater than the voltage at the second node 624, then the first LED 126 illuminates. Also, if the voltage at the third circuit node 626 is significantly lower than the voltage at the fourth circuit node 628, then the third LED 634 illuminates.

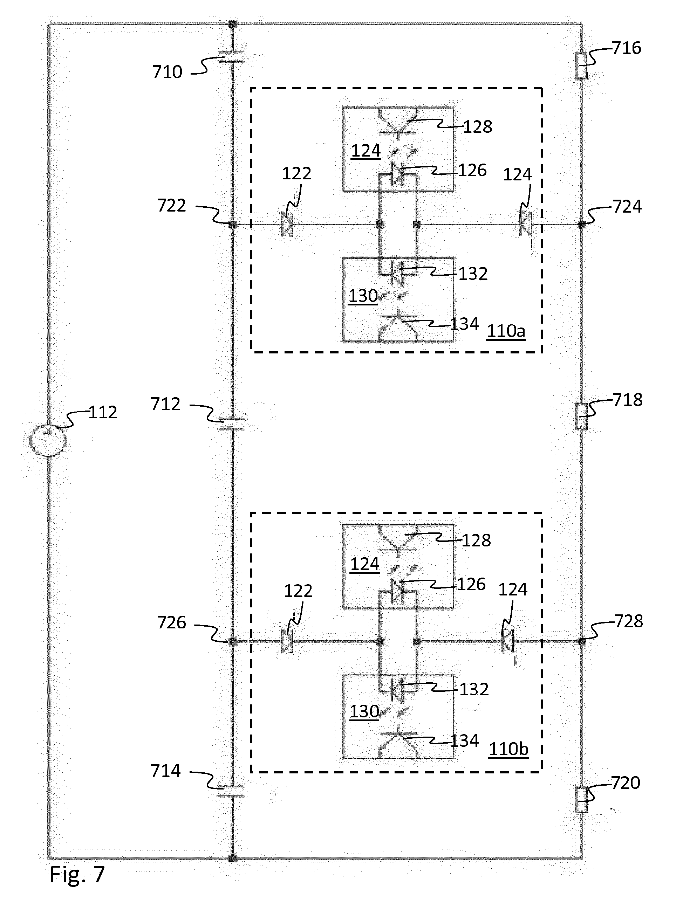

In Figure 7, first, second and third capacitors 710, 712, 714 are arranged in series and the series arranged capacitors are in parallel with first second and third resistors 716, 718, 720. Furthermore, a first capacitor failure indication circuit 110a as described with reference to Figure 1 is connected in between first and second circuit nodes 722, 724 which respectively represent the common connection point of the first and second capacitors 710, 712 and the common connection point of the first and second resistors 716, 718. A second capacitor failure indication circuit 110b, also as described with reference to Figure 1, is connected between third and fourth circuit nodes 726, 728 which respectively represent the common connection points of the second and third capacitors 712, 714 and the common connection point of the second and third resistors 718, 720.

When the circuit of Figure 7 is in operation, in the event that the voltage at the first circuit node 722 is significantly lower than that at the second circuit node 724, then the second LED 132 of the first capacitor failure indication circuit 110a will illuminate. In the event that the voltage at the first circuit node 722 is significantly greater than the voltage at the second node 724, then the first LED 126 of the first capacitor failure indication circuit 110a will illuminate. Also, if the voltage at the third circuit node 726 is significantly higher than the voltage at the fourth circuit node 728, then the first LED 126 of the second capacitor failure indication circuit 110b will illuminate and, if the voltage at the third circuit node 726 is significantly lower than the voltage at the fourth circuit node 728, then the second LED 132 of the second capacitor failure indication circuit 110b will illuminate.

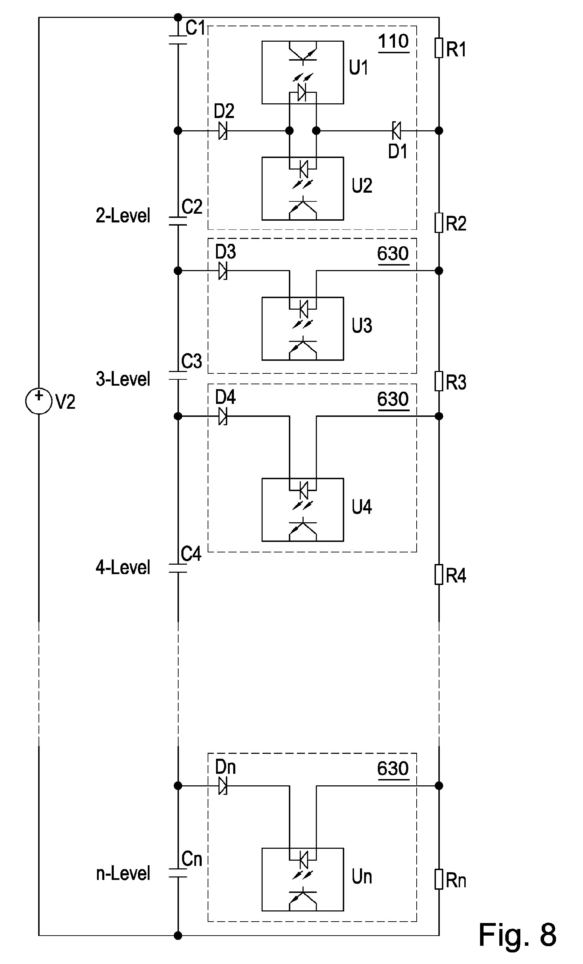

Figure 8 shows a circuit diagram in which the approaches described above can be extrapolated to any number of series connected capacitors and series connected resistors that are together connected in parallel. The circuit of Figure 8 comprises a capacitor failure indication circuit 110 as described with reference to Figure 1 and a number of additional circuit levels each comprising: an additional capacitor and resistor (C3 to CN, and R3 to RN), a Zener diode, and an optocoupler arrangement 630 as described with reference to Figure 6. As can be seen from Figure 8, the series connected first and second capacitors are connected in parallel to the series connected first and second resistors via the series connected third to n^{th} capacitors and the series connected third to n^{th} resistors. In the circuit of Figure 8, the ratio of the impedance of the n^{th} capacitor to the sum of the impedances of the first to n^{th} capacitors is the same as the ratio of the impedance of the n^{th} resistor to the sum of the impedances of the first to n^{th} resistors.

A person skilled in the art will understand that the concept of extrapolating the circuit of Figure 6 so as to arrive at the circuit of Figure 8 could also be performed for the circuit of Figure 7 in which case, for each additional resistor and capacitor level, a further capacitor failure indication circuit 110 would be added and the ratio of the impedance of the n^{th} capacitor to the sum of the impedances of the first to n^{th} capacitors would be the same as the ratio of the impedance of the n^{th} resistor to the sum of the impedances of the first to n^{th} resistors.

Furthermore, the circuit of Figure 5 could likewise be extrapolated and in such a case it would be only be the n^{th} level of the circuit that would have a capacitor failure indication circuit 110 as shown in Figure 5 and for each further layer the capacitor failure indication circuit 530 would be present and the ratio of the sum of the impedances of the first to n-1^{th} capacitors to the sum of the impedances of the first to n^{th} capacitors would be the same as the ratio of the sum of the impedances of the first to n-1^{th} resistors to the sum of the impedances of the first to n^{th} resistors.

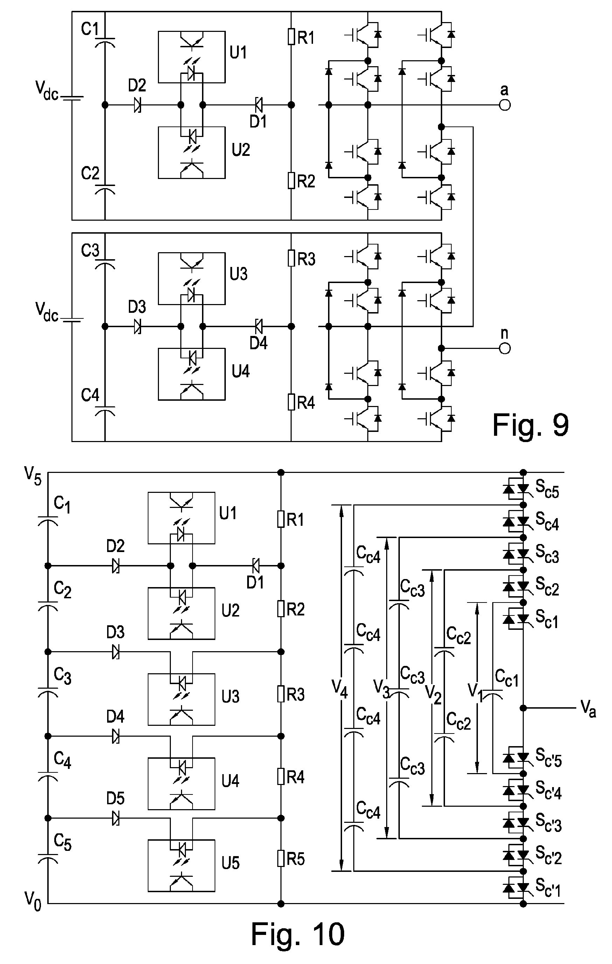

Figure 9 shows a circuit in which a pair of the circuits of Figure 1 are connected together using a three level diode clamped converter to increase the output voltage level. Such a circuit may be appropriate for use in situations where the applied voltage is provided by a solar panel and it is desired to step up the voltage provided by a plurality of panels.

Figure 10 shows a circuit described herein that is applied as one leg of a three phase six level flying capacitor inverter.

The capacitor failure indication circuit described herein may be employed to detect failures of DC interlink capacitors connected in series, as may be employed for devices that use rectified voltages. Example of such devices include: AC/DC Drives, UPS (Uninterruptable Power Supplies), multilevel converters, variable frequency drives, battery banks (for example those that are charged using a rectified AC/DC converter - as may be used to back up an inverter), and solar panels.

Although the present disclosure has been set out with reference to examples in which LEDs, and preferably those contained within sealed optocouplers, are used to indicate capacitor failure, any other electrical light source, for example a light bulb, could be used instead of any of the LEDs described herein. Furthermore, a signal developed by the phototransistor of an optocoupler as a consequence of that optocoupler's LED having illuminated may be used to drive an externally visible LED or an alarm or buzzer in order to provide an external indication of capacitor failure.

Component and voltage values set out herein are provided to assist with the understanding of the present disclosure and the concepts and circuits described herein may equally be implemented using different component and/or voltage values without departing from the scope of the present disclosure.

There is described herein a circuit arranged to detect a voltage imbalance indicative of component failure and, upon such detection, convey an optical signal to indicate that a component appears to have failed.

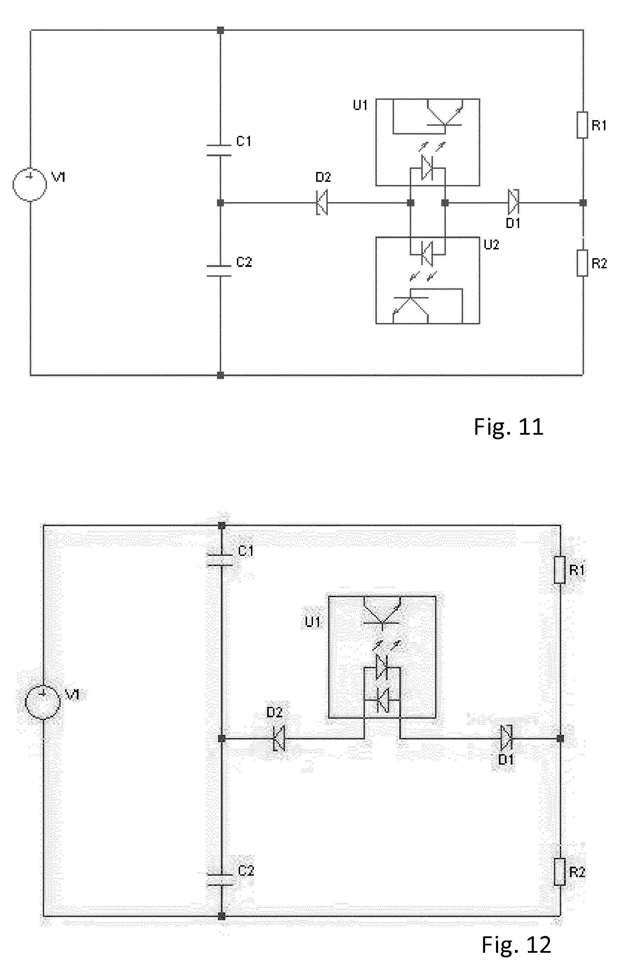

As one possibility, for any of the examples described above, the position of the first Zener diode, the first (and second if present) LED, and/or the second Zener diode may be transposed in any order so long as the anode and cathode orientations of the diodes with respect to the first and second circuit nodes is maintained. This applies equally to the components of each layer in systems having a plurality of capacitor failure indication circuits. When transposing the components, it can help to view the capacitor failure indication circuit as a plurality of circuit blocks, each having a first and second connection and being connected in series. If one of the blocks has a Zener diode in a particular orientation, another of the blocks has a pair of LEDs, and yet another of the blocks has another Zener diode in a different orientation to that of the other Zener diode, then the blocks may be arranged in any sequence so long as they remain in series and do not have the orientation of their respective components changed. As an example, Figure 11 show a circuit based upon that of Figure 1, but with the first and second Zener diodes transposed whilst their anode and cathode orientation with respect to the first and second circuit nodes is maintained. As a further example, Figure 12 show a circuit based upon that of Figure 2, but with the first and second Zener diodes transposed whilst their anode and cathode orientation with respect to the first and second circuit nodes is maintained. In some circumstances, it may only be practicable to perform such a transposition in the event that the Zener diodes have the same Zener breakdown voltages.

## Claims

1. A capacitor failure indication circuit, the capacitor failure indication circuit being arranged for connection between a first circuit node and a second circuit node, wherein:
the first circuit node is the common connection point of a first capacitor and a second capacitor that are connected in series;
the second circuit node is the common connection point of a first resistor and a second resistor that are connected in series;
the series connected first and second capacitors are connected in parallel to the series connected first and second resistors; and
the ratio of the impedance of the second capacitor to the sum of the impedances of the first and second capacitors is the same as the ratio of the impedance of the second resistor to the sum of the impedances of the first and second resistors, the capacitor failure indication circuit comprising:
first, second, and third circuit blocks, each having first and second connections, wherein:
the first connection of the first circuit block is arranged for connection to the first circuit node;
the first connection of the second circuit block is connected to the second connection of the first circuit block;
the first connection of the third circuit block is connected to the second connection of the second circuit block and the second connection of the third circuit block is arranged for connection to the second circuit node;
one of the first, second, and third circuit blocks has a first Zener diode having its anode connected to the first connection of that circuit block and its cathode connected to the second connection of that circuit block;
another of the first, second, and third circuit blocks has a first Light Emitting Diode, LED, having its anode connected to the first connection of that circuit block and its cathode connected to the second connection of that circuit block and a second LED having its anode connected to the second connection of that circuit block and its cathode connected to the first connection of that circuit block; and
yet another of the first, second, and third circuit blocks has a second Zener diode having its cathode connected to the first connection of that circuit block and its anode connected to the second connection of that circuit block.

2. The capacitor failure indication circuit of claim 1 further comprising a first integral optocoupler comprising the first LED and a first phototransistor.

3. The capacitor failure indication circuit of claim 2 further comprising a second integral optocoupler comprising the second LED and a second phototransistor.

4. The capacitor failure indication circuit of claim 1 further comprising an integral optocoupler comprising the first and second LEDs and a first phototransistor.

5. The capacitor failure indication circuit of any preceding claim, further comprising the first and second resistors.

6. The capacitor failure indication circuit of claim 5, further comprising the first and second capacitors.

7. A multiple capacitor failure indicator circuit comprising the capacitor failure indication circuit of claim 6, wherein the side of the second capacitor that is not connected to the common connection point of the first capacitor and the second capacitor forms a third node of the capacitor failure indication circuit and the side of the second resistor that is not connected to the common connection point of the first resistor and the second resistor forms a fourth node of the capacitor failure indication circuit, the multiple capacitor failure indicator circuit further comprising:
n additional capacitor failure indication circuits, wherein n is a positive integer greater than 2 and each n^{th} additional capacitor failure indication circuit comprises:
an n^{th} capacitor connected between n^{th} first and second capacitor nodes of the n^{th} additional capacitor failure indication circuit;
an n^{th} resistor connected between n^{th} first and second resistor nodes of the n^{th} additional capacitor failure indication circuit; and
n^{th} first and second circuit blocks, each having first and second connections, the ratio of the sum of the impedances of the first to n-1^{th} capacitors to the sum of the impedances of the first to n^{th} capacitors being the same as the ratio of the sum of the impedances of the first to n-1^{th} resistors to the sum of the impedances of the first to n^{th} resistors, wherein:
the first connection of the n^{th} first circuit block is connected to the n^{th} first resistor node;
the first connection of the n^{th} second circuit block is connected to the second connection of the n^{th} first circuit block and the second connection of the n^{th} second circuit block is connected to the n^{th} first capacitor node;
one of the n^{th} first and second circuit blocks has an n^{th} Zener diode having its anode connected to the first connection of that circuit block and its cathode connected to the second connection of that circuit block;
the other another of the n^{th} first and second circuit blocks has an n^{th} LED having its anode connected to the second connection of that circuit block and its cathode connected to the first connection of that circuit block
the first capacitor and resistor nodes of the 3^{rd} additional capacitor failure indication circuit are respectively connected to the third and fourth nodes of the capacitor failure indication circuit;
for any 4^{th} or subsequent additional capacitor failure indication circuit, the n^{th} first capacitor and resistor nodes are respectively connected to the (n-1)^{th} second capacitor and resistor nodes; and
the series connected first and second capacitors are connected in parallel to the series connected first and second resistors via the 3^{rd} to n^{th} capacitors and the 3^{rd} to n^{th} resistors.

8. A multiple capacitor failure indicator circuit comprising the capacitor failure indication circuit of claim 6, wherein the side of the second capacitor that is not connected to the common connection point of the first capacitor and the second capacitor forms a third node of the capacitor failure indication circuit and the side of the second resistor that is not connected to the common connection point of the first resistor and the second resistor forms a fourth node of the capacitor failure indication circuit, the multiple capacitor failure indicator circuit further comprising:
n additional capacitor failure indication circuits, wherein n is a positive integer greater than 2 and each n^{th} additional capacitor failure indication circuit comprises:
an n^{th} capacitor connected between n^{th} first and second capacitor nodes of the n^{th} additional capacitor failure indication circuit;
an n^{th} resistor connected between n^{th} first and second resistor nodes of the n^{th} additional capacitor failure indication circuit; and
n^{th} first and second circuit blocks, each having first and second connections, the ratio of the impedance of the n^{th} capacitor to the sum of the impedances of the first to n^{th} capacitors being the same as the ratio of the impedance of the n^{th} resistor to the sum of the impedances of the first to n^{th} resistors, wherein:
the first connection of the n^{th} first circuit block is connected to the n^{th} first capacitor node;
the first connection of the n^{th} second circuit block is connected to the second connection of the n^{th} first circuit block and the second connection of the n^{th} second circuit block is connected to the n^{th} first resistor node;
one of the n^{th} first and second circuit blocks has an n^{th} Zener diode having its anode connected to the first connection of that circuit block and its cathode connected to the second connection of that circuit block;
the other another of the n^{th} first and second circuit blocks has an n^{th} LED having its anode connected to the second connection of that circuit block and its cathode connected to the first connection of that circuit block;
the first capacitor and resistor nodes of the 3^{rd} additional capacitor failure indication circuit are respectively connected to the third and fourth nodes of the capacitor failure indication circuit;
for any 4^{th} or subsequent additional capacitor failure indication circuit, the n^{th} first capacitor and resistor nodes are respectively connected to the (n-1)^{th} second capacitor and resistor nodes; and
the series connected first and second capacitors are connected in parallel to the series connected first and second resistors via the 3^{rd} to n^{th} capacitors and the 3^{rd} to n^{th} resistors.

9. A multiple capacitor failure indicator circuit comprising the capacitor failure indication circuit of claim 6, wherein the side of the second capacitor that is not connected to the common connection point of the first capacitor and the second capacitor forms a third node of the capacitor failure indication circuit and the side of the second resistor that is not connected to the common connection point of the first resistor and the second resistor forms a fourth node of the capacitor failure indication circuit, the multiple capacitor failure indicator circuit further comprising:
n additional capacitor failure indication circuits, wherein n is a positive integer greater than 2 and each n^{th} additional capacitor failure indication circuit comprises:
an n^{th} capacitor connected between n^{th} first and second capacitor nodes of the n^{th} additional capacitor failure indication circuit;
an n^{th} resistor connected between n^{th} first and second resistor nodes of the n^{th} additional capacitor failure indication circuit; and
n^{th} first, second, and third circuit blocks, each having first and second connections, the ratio of the impedance of the n^{th} capacitor to the sum of the impedances of the first to n^{th} capacitors being the same as the ratio of the impedance of the n^{th} resistor to the sum of the impedances of the first to n^{th} resistors, wherein:
the first connection of the n^{th} first circuit block is connected to the n^{th} first capacitor node;
the first connection of the n^{th} second circuit block is connected to the second connection of the n^{th} first circuit block;
the first connection of the n^{th} third circuit block is connected to the second connection of the n^{th} first circuit block and the second connection of the n^{th} third circuit block is connected to the n^{th} first resistor node;
one of the n^{th} first, second, and third, circuit blocks has an n^{th} first Zener diode having its anode connected to the first connection of that circuit block and its cathode connected to the second connection of that circuit block;
another of the n^{th} first, second, and third circuit blocks has an n^{th} first LED having its anode connected to the second connection of that circuit block and its cathode connected to the first connection of that circuit block and an n^{th} second LED having its anode connected to the first connection of that circuit block and its cathode connected to the second connection of that circuit block;;
yet another of the n^{th} first, second, and third, circuit blocks has an n^{th} second Zener diode having its anode connected to the second connection of that circuit block and its cathode connected to the first connection of that circuit block;
the first capacitor and resistor nodes of the 3^{rd} additional capacitor failure indication circuit are respectively connected to the third and fourth nodes of the capacitor failure indication circuit;
for any 4^{th} or subsequent additional capacitor failure indication circuit, the n^{th} first capacitor and resistor nodes are respectively connected to the (n-1)^{th} second capacitor and resistor nodes; and
the series connected first and second capacitors are connected in parallel to the series connected first and second resistors via the 3^{rd} to n^{th} capacitors and the 3^{rd} to n^{th} resistors.

10. A capacitor failure indication circuit comprising:
first, second, and third circuit blocks, each having first and second connections, wherein:
the first connection of the second circuit block is connected to the second connection of the first circuit block;
the first connection of the third circuit block is connected to the second connection of the second circuit block;
one of the first, second, and third circuit blocks has a first Zener diode having its anode connected to the first connection of that circuit block and its cathode connected to the second connection of that circuit block;
another of the first, second, and third circuit blocks has a first Light Emitting Diode, LED, having its anode connected to the first connection of that block and its cathode connected to the second connection of that circuit block and a second LED having its anode connected to second connection of that circuit block and its cathode connected to first connection of that circuit block; and
yet another of the first, second, and third circuit blocks has a second Zener diode having its cathode connected to the first connection of that circuit block and its anode connected to the second connection of that circuit block.

11. A system comprising:
the circuit of any preceding claim; and
a disruptor circuit arranged to detect illumination of one or more of the LEDs and, upon such detection, disrupt a voltage supplied to the series connected capacitors.

12. The system of claim 11, wherein the disruptor circuit is arranged to disrupt the voltage by removing a thyristor gate signal.

13. The system of claim 11 or 12, wherein the disruptor circuit is arranged to disrupt the voltage by connecting an inrush resistor to the system.
